Europäisches Patentamt

European Patent Office

Office européen des brevets

(19)

(11) Publication number: **0 065 797**
**B1**

(12) **EUROPEAN PATENT SPECIFICATION**

(45) Date of publication of patent specification: **09.09.87**

(51) Int. Cl.⁴: **G 11 C 19/08**

(21) Application number: **82200543.5**

(22) Date of filing: **06.05.82**

(54) **Current-controlled register for propagating magnetic domains and magnetic domain memory using a plurality of such registers.**

(30) Priority: **11.05.81 NL 8102284**

(43) Date of publication of application:
**01.12.82 Bulletin 82/48**

(45) Publication of the grant of the patent:
**09.09.87 Bulletin 87/37**

(84) Designated Contracting States:
**DE FR GB NL**

(56) References cited:
**GB-A-2 057 211**

**JOURNAL OF APPLIED PHYSICS, vol. 49, no. 3/2, March 1978, pages 1927-1929, New York, USA; E.H.L.J.DEKKER et al: "Conductor and transfer-gate performance of single-mask field-current access magnetic-bubble devices"**

(73) Proprietor: **N.V. Philips' Gloeilampenfabrieken**
**Groenewoudseweg 1**
**NL-5621 BA Eindhoven (NL)**

(72) Inventor: **Wiegman, Nelie Jansje**
**c/o INT.OCTROOIBUREAU B.V. Prof.Holstlaan 6**
**NL-5656 AA Eindhoven (NL)**

(74) Representative: **Koppen, Jan et al**
**INTERNATIONAAL OCTROOIBUREAU B.V. Prof. Holstlaan 6**
**NL-5656 AA Eindhoven (NL)**

## Description

The invention relates to a register for propagating cyclindrical magnetic domains in a magnetizable layer, of the type in which the cylindrical magnetic domains are propagated under the influence of a bipolar current drive along a path which is defined by a meandering conductor pattern in combination with control elements arranged along the longitudinal axis of the conductor pattern, two per meander period of the conductor pattern, where the conductor pattern comprises a conductor having a width of substantially one domain diameter, and a meander period of substantially four domain diameters, where the control elements, at least during operation of the register, are magnetized to present a magnetic in-plane orientation which makes an angle of substantially 45° with the longitudinal axis of the conductor pattern.

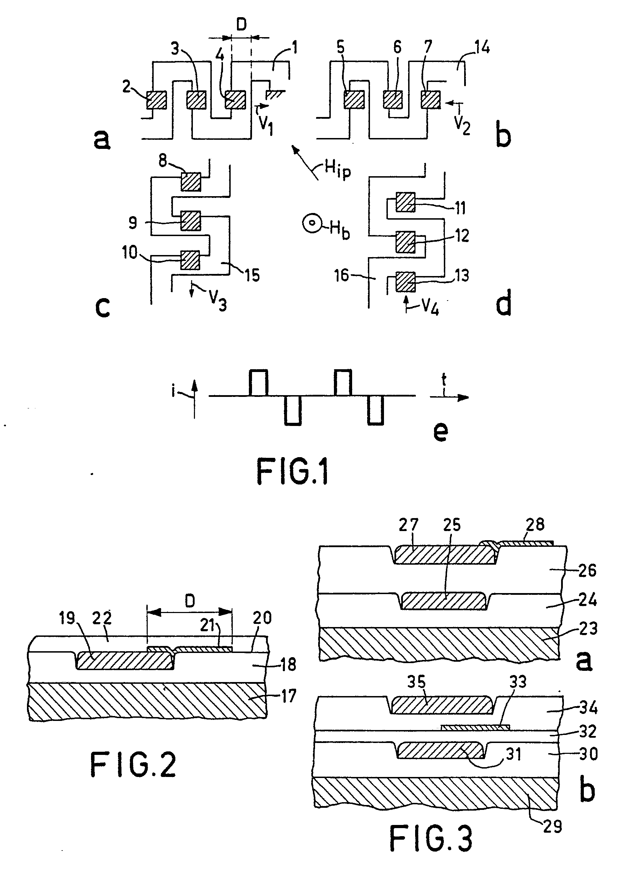

Such a register for propagating magnetic domains is known from Journal of Applied Physics, Vol. 50, No. 3, March 1979, pp. 2277-79. The shift register shown in Figure 2 of the said article comprises a meander-shaped current conductor controlled by a bipolar current and T-shaped elements of a nickel-iron alloy which generate potential wells at the desired places under the influence of a magnetic field in the plane of the magnetizable layer. These wells serve mainly to stabilize the cylindrical magnetic domains in the layer at instants at which no current passes through the conductor. The configuration of this known shift register, which was destined for the propagation of magnetic domains having a diameter of 4 μm, is such that the smallest detail of the masks required in the manufacture thereof is necessarily equal to approximately half a domain diameter. In the manufacture of shift registers in which domains having a diameter of 2 μm or even smaller have to be propagated, serious problems are encountered. Moreover, the configuration is such that propagation of the domains is possible only in one direction, or in two (orthogonal) directions, so that electric writing back in the memory of which the shift register forms part is always necessary and a major-minor loop organization cannot be realized.

A register for propagating magnetic domains, with rectangular control elements which are centered on the windings of the meandering conductor, seen in the direction of propagation, is disclosed in GB—A—2057211 on which the preamble of claim 1 is based. Such a register can be used in a serially organized memory arrangement.

It is the object of the invention to provide a shift register of the kind mentioned in the opening paragraph having such a configuration that the smallest detail is not necessarily equal to half the diameter of the domains to be propagated and which moreover has the possibility of causing the propagation to take place in any of four desired orthogonal directions.

This object is achieved by the invention as claimed, which is characterized in that the control elements are lamellar magnetic regions of substantially square or circular cross-section which, in their magnetized state, generate potential wells which each, in the plane of the magnetizable layer, contains an area which substantially equals the cross-section of a domain, and in that the control elements have off-axis positions relative to the axis of the meandering conductor to stabilize the centres of the domains at the edges of the conductor pattern when the current through the conductor pattern is zero, where the control elements are substantially aligned along the propagation axis.

The particular configuration of the domain propagation register according to the invention makes it possible, for example, for the propagation of domains having a cross-section of 2 μm to use a meandering conductor having a period of 8 μm and a dimension of the smallest detail of 2 μm. For the control elements for generating the potential wells deposited lamellar regions of a soft-magnetic alloy may be used in combination with an inplane magnetic field for giving them the required orientation, or deposited lamellar regions of permanent magnetic material which are magnetized in a direction obliquely to the longitudinal axis of the conductor pattern may be used. It was found that the shift register has a satisfactory operation as long as the edges of the deposited regions are not more than 1 μm remote from the places where they should be. The effect of a not completely correct alignment of the lamellar regions can be compensated for by varying the current through the conductor or (only in the former case) by varying the strength of the inplane magnetic field. The two mask configuration of the register in accordance with the invention (one mask for the conductor pattern, one mask for the soft-magnetic or permanent magnetic control elements), thus does not involve serious alignment problems.

In addition to this extra advantage, a further advantage of the particular configuration of the register in accordance with the invention is that the control elements give rise to a pseudo-drive of the domains. After switching off the current through the conductor a domain covers the remaining part (approximately ⅓) of the distance to be covered under the influence of the attraction of the next control element. This is of importance for restricting the dissipation.

The lamellar regions forming the control elements for generating potential wells may in known manner alternatively be formed by ion-implanted regions at the surface of the magnetizable layer, or by differences in height in the magnetizable layer, both in combination with an in-plane field oblique to the longitudinal axis of the conductor pattern. In the specific case that the lamellar regions forming the control elements have a square or a circular shape the length of their sides or their diameter, respectively, is approximately equal to the diameter of the cross-section of a domain.

The direction of propagation of the domains depends on the positions of the control elements which are arranged with a pitch equal to half a period of the conductor pattern and on either the direction of the in-plane magnetic field if the control elements comprise soft magnetic material or on the direction of magnetization of the elements, if these comprise permanently magnetic material. As will be described in detail hereinafter four different directions of domain propagation are possible, for example, if there is an angle of 45° (or 135°) between the direction of magnetization of the control elements and the longitudinal axis of the conductor pattern; if such an angle is present the base for a major-minor loop organization has been laid.

A current controlled magnetic domain memory having major-minor loop organization is known *per se* from Bell System Technical Journal 58, pp. 1453—1540, see in particular pp. 1499 and 1500. However, the system described there is of the type which, for the propagation of the domains, uses two conductor layers each comprising a hole pattern and separated by an intermediate layer. Disadvantages of this known system are that there is a fair chance that an electric contact occurs between the two conductor layers and that it is sensitive to magnetic domains the domain wall state of which differs from the s=0 state. As a result of this, domains may deviate from the desired path during their movement. In order to mitigate this, a very strong in-plane magnetic field is necessary. According to the invention, the disadvantages of the known current-controlled domain memory having major-minor loop organization (that is to say a main control path for the input and output of information, which path is coupled to a number of information storage loops), can be avoided by using, instead of two conductor layers with perforations, two conductor layers which are characterized in that the first conductor layer comprises a number of parallel registers as claimed in any of claims 1—4 and that the second conductor layer comprises a number of parallel registers as claimed in any of claims 1—4 which cross the registers of the first conductor layer with an angle of substantially 90°, in which a magnetic element is provided at the crossing points which is shared between the registers in the first and the second layers, each two adjacent conductor patterns of the first layer together with two adjacent registers of the second layer defining an information storage loop. In such a system, two conductor layers are present above each other only in a very small part of the memory so that the possibility of electric contact between the two conductor layers is very small. In addition the system proves to be insensitive to domains having s≠0 walls.

The most practical embodiment of this memory system is characterized in that the meandering conductor patterns of the registers of the first and second conductor layers have the same meander periods.

A domain memory in accordance with the invention having crossing systems of meandering conductor patterns which together form the required information storage loops can be constructed in various ways.

A first embodiment is characterized in that two successive conductor patterns of the first layer define a main control path and a loop-closing path.

A second embodiment is characterized in that three successive conductor patterns of the first layer define a main control path present between two loop-closing paths, the main control path in conjunction with one loop-closing path and two successive conductor paths of the second conductor layer forming an information storage loop having a first direction of rotation, the main control path in conjunction with the other loop-closing path and two successive conductor patterns of the second conductor layer forming an information storage loop having a second direction of rotation opposite to the first.

In order to complete the above domain memory embodiments, the main control path may have a first end which is connected to a domain generator and a second end which is connected to a domain detector.

If the lamellar regions which form the control elements of the registers of the first and second layer consist of deposits of soft magnetic or permanent magnetic material, they may either be all arranged in the intermediate layer between the first and second conductor layers, or be all arranged in a layer which adjoins the free surface of the conductor layer which is farthest from the magnetizable layer.

The invention relates not only to a current-control domain memory having major-minor loop organisation, it also relates to a current-controlled domain memory having a series-parallel-series organisation. In that case successive conductor patterns in the first layer form a serially driven input register and a serially driven output register for magnetic domains, respectively, and the conductor patterns in the second layer form parallel driven domain movement registers.

The invention will now be described in greater detail, by way of example, with reference to the drawings.

Figures 1a, 1b, 1c and 1d are plan views of parts of domain propagation registers according to the invention for propagating magnetic domains in first, second, third and fourth directions, respectively. Figure 1e shows an energization diagram.

Figure 2 is a cross-sectional view through a domain propagation register according to the invention.

Figures 3a and 3b are cross-sectional views through parts of two different embodiments of a magnetic domain memory in accordance with the invention.

Figure 4 is a plan view of a magnetic domain memory having a major-minor loop organisation according to the invention.

Figures 5a, 5b, 5c and 5d each show a part of Figure 4 on an enlarged scale.

A meandering current conductor 1 having a conductor width D (D being approximately the diameter of a magnetic domain) and a period 4D and provided with soft-magnetic control elements 2, 3, 4 (see Figure 1a) which is present in an in-plane magnetic field $H_{ip}$, is driven by bipolar pulses (Figure 1e). The control elements 2, 3, 4 in this case are squares having dimensions D×D but may alternatively be discs having a diameter D. The direction of propagagation of a magnetic domain propagated by means of the register in Figure 1a, which domain is maintained under the influence of a main magnetic field $H_b$ which is transverse to the plane of the conductor, depends on the positioning of the control elements 2, 3, 4 and the direction of the conductor relative to the direction of the in-plane field $H_{ip}$. With the direction of the in-plane field $H_{ip}$ shown, the Figures 1a, 1b, 1c and 1d give four different directions of propagation $V_1$, $V_2$, $V_3$ and $V_4$ of the magnetic domains.

Under the influence of the field $H_{ip}$, the elements 2, 3, 4, as well as the elements 5, 6, 7; 8, 9, 10; and 11, 12, 13, generate potential wells which stabilize magnetic domains at the area of the edges of the conductors 1, 14, 15, 16 when no current passes therethrough.

So with the configuration shown in Figures 1a to 1d propagation in any one of four desired directions is possible. In addition, the smallest detail is as large as possible. This is equal to D.

Figure 2 is a cross-sectional view of a magnetizable layer 17 in which magnetic domains can be propagated. The layer 17 is covered with a layer 18 of a non-magnetic, non-electrically conductive material, for example $SiO_x$ (1≤x≤2). Electric conductors of the type shown in Figures 1a to 1d are embedded in the layer 18. One representative thereof is denoted by reference numeral 19. The conductor 19 may consist, for example, of Al.

By embedding the conductor 19 in the layer 18 it can be ensured that a flat surface 20 is formed on which soft magnetic control elements can be provided. One such control element is denoted by reference numeral 21. A passivating layer 22 which may consist, for example, of $SiO_x$ (1≤x≤2) is provided over the element 21.

The thickness of the control element 21, which may consist, for example, of a nickel-iron alloy (permalloy), is much smaller than is usual for control elements: 100 nm instead of 400 nm, and the element dimensions are approximately D×D instead of it being elongate having a length exceeding D as is described in the above-cited Journal of Applied Physics 50 (1979). As a result of this the potential well caused by element 21 is so small that in the situation of Figures 1b and 1d stripping-out (changing its circular cross-section into an elongated cross-section of a domain in the direction of propagation is prevented. Stripping-out would have for its result that the operational margin of the configurations shown in Figures 1b and 1d would be much smaller than that of the configurations 1a and 1c.

The depth of the potential well caused by element 21 can be accurately adjusted by

1. varying the thickness of the element;
2. varying the distance from element 21 to magnetizable layer 17 (either by varying the thickness of the layer 18 or by providing an extra intermediate layer from 50 to 150 nm thick between element 21 and layer 18;
3. varying the strength of the in-plane magnetic field $H_{ip}$.

All this makes it possible to optimize the driving force with which a magnetic domain is attracted towards the element 21 and the pinning force which occurs when a domain is pulled off from the element 21 under the influence of current through the conductor 19, so that a minimum propagation current is required.

The distance between the layers 17 and 19, as well as the thickness of 19, will generally be a few 100 nm, for example 400 nm. If it is necessary for the operation of the system, the distance may be made smaller. In order to prevent the occurrence of mechanical stresses in the layer 18 a synthetic resin, for example a polyamide, may alternatively be used as a material for the layer 18. A layer of synthetic resin can better compensate for mechanical stresses, if any, than a (thin) $SiO_x$ layer.

A very suitable technology for manufacturing the layer structure shown in the cross-sectional view of Figure 2 is the planar technology as described by T. W. Bril, R. de Werdt en P. Willemse in Paper 77 of the E.C.S. Spring Meeting in St. Louis (11—16 May, 1980).

Figures 3a and 3b are cross-sectional views of two layer structures which may be employed when two conductor layers are provided.

Figure 3a shows a detail of a cross-sectional view through a control structure which is present above magnetizable layer 23 in which cylindrical magnetic domains can be propagated, which structure comprises a conductor 25 which is embedded in a spacer layer 24 and a conductor 27 which is embedded in a spacer layer 26. The conductors 25 and 27 may form part of meandering conductor patterns which cross each other. A control element 28 of permalloy is present partly on the layer 26 and partly on the conductor 27.

Figure 3b shows a detail of an alternative construction of a control structure which in this Figure is present above a magnetizable layer 29 and comprises a conductor 31 embedded in a spacer layer 30 and conductor 35 embedded in a spacer layer 34. A control element 33 of permalloy is separatd from the layer 30 by a spacer layer 32.

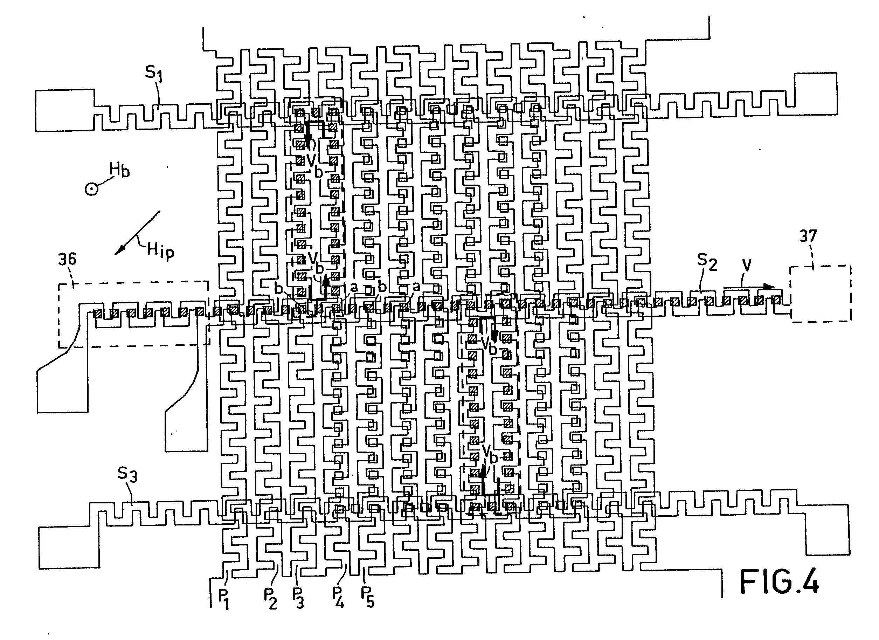

Figure 4 shows a 3-layer domain memory having a major-minor loop organisation and comprising two conductor layers and a permalloy layer for the control elements.

In the first layer, three current-controlled propagation paths for cylindrical magnetic domains, so-called "bubbles", are provided, namely $S_1$, $S_2$ and $S_3$. The meandering paths $P_1$, $P_2$, $P_3$, $P_4$, $P_5$... are provided in the second layer and permalloy control elements indicated by shaded squares are provided in the third layer. The meander $S_2$ serves for reading-in and reading-out the information. All meanders provided in the first and the second conductor layer together constitute the minor loops in which the information storage takes place.

A minor loop (see Figure 4) is formed by two successive meanders in the second layer together with parts of the conductors $S_2$ and $S_1$ for an upper minor loop, and parts of $S_2$ and $S_3$ for a lower minor loop.

By driving $S_2$ the information is transported from a generator 36 to the memory (one bubble in each period of the meander). When the bubbles have arrived at the positions denoted by a and b, the driving of $S_2$ is discontinued and the conductors $P_1$, $P_2$, $P_3$, $P_4$, $P_5$, etc. are driven for one period. The bubbles are now moved in the minor loops over one bit place; the bubbles in the positions "a" move upwards, those in the positions "b" move downwards. Simultaneously, information from the minor loops becomes positioned in the in/out path $S_2$.

Information from the upper minor loops comes into the "b"-places and that from the lower loops into the "a"-places. This information is conducted to a detector 37 simultaneously with reading-in the next information. Reading in and reading-out occurs at a frequency f.

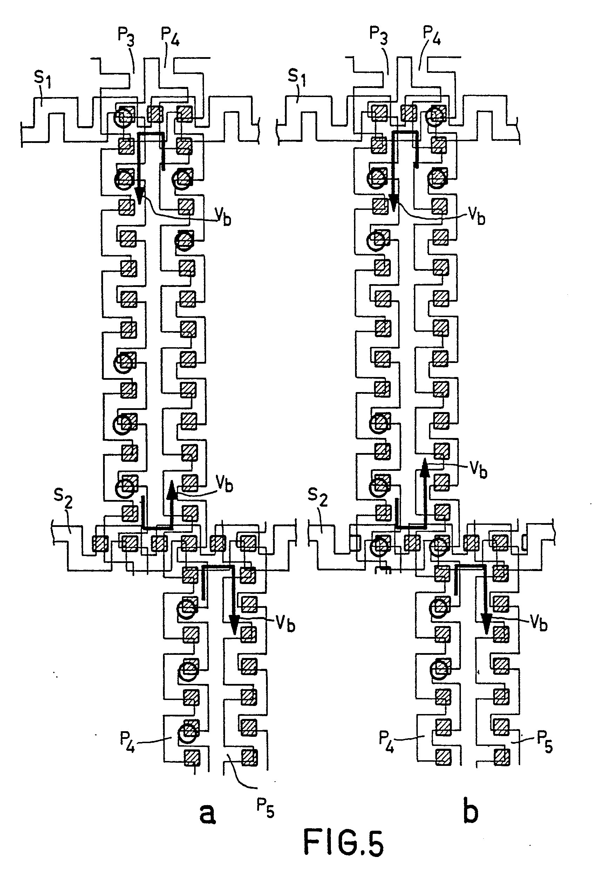

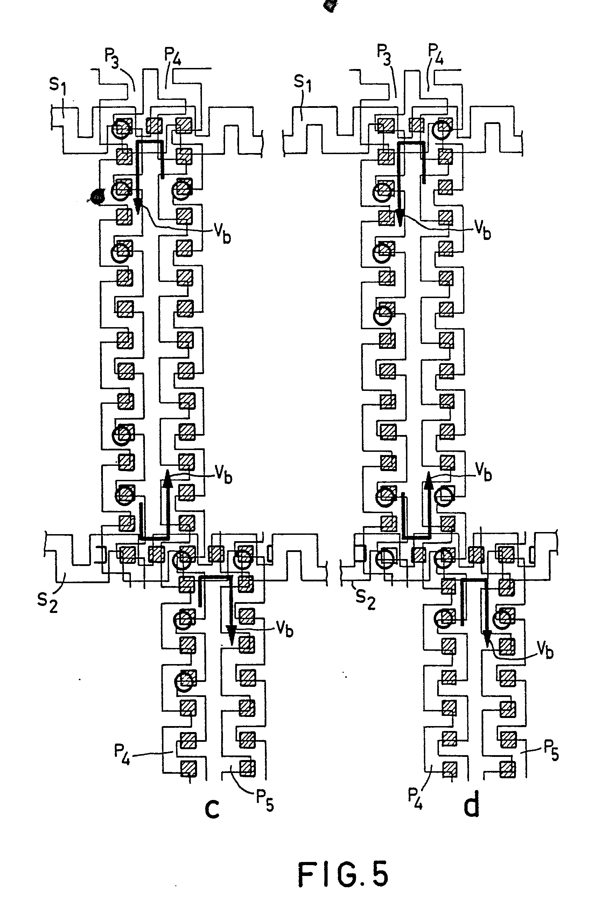

In order to circulate the bubbles in the minor loops, the S-conductors are energized for one period ("positive pulse+negative pulse") and the P-conductors for one period (=positive pulse+negative pulse) alternately. The movement of bubbles through a minor loop is followed in Figures 5a to 5d. The starting situation is shown in Figure 5a with reference to two (=upper+lower) minor loops. After driving the P-conductors for one period the situation as shown in Figure 5b is obtained. Energization of the conductors $S_1$, $S_2$ and $S_3$ is then carried out for one period resulting in the situation shown in Figure 5c. Again driving the P-conductors for one period yields the situation shown in Figure 5d. The circulation frequency in the minor loops is f/2. A minor loop of m periods may at most contain (m−2) bits of information.

It is to be noted that:

—The first and second conductor layers may in principle be alternated.

—Searching in the minor loop for a block of information which is to be read occurs at half the frequency f. When this block of information reaches the in/out transfer path, reading-out of the whole block as well as reading-in of the possible new information occurs at frequency f.

—In a series-parallel-series organisation the only difference is that successive meanders $P_1$, $P_2$, etc. have the same configurations so that the bubbles are driven in parallel along the meanders of the second layer.

## Claims

1. A register for propagating cylindrical magnetic domains in a magnetizable layer, of the type in which the cylindrical magnetic domains are propagated under the influence of a bipolar current drive along a path which is defined by a meandering conductor pattern in combination with control elements (2—13) arranged along the longitudinal axis of the conductor pattern, two per meander period of the conductor pattern, where the conductor pattern comprises a conductor (1) having a width of substantially one domain diameter, and a meander period of substantially four domain diameters, where the control elements (2—13), at least during operation of the register, are magnetized to present a magnetic in-plane orientation which makes an angle of substantially 45° with the longitudinal axis of the conductor pattern, characterized in that the control elements (2—13) are lamellar magnetic regions of substantially square or circular cross-section which, in their magnetized state, generate potential wells which each, in the plane of the magnetizable layer, contains an area which substantially equals the cross-section of a domain, and in that the control elements (2—13) have off-axis positions relative to the axis of the meandering conductor to stabilize the centres of the domains at the edges of the conductor pattern when the current through the conductor pattern is zero, where the control elements (2—13) are substantially aligned along the propagation axis.

2. A register as claimed in Claim 1, characterized in that the lamellar magnetic regions (2—13) comprise a soft magnetic material, are arranged in one plane and during operation of the register have the required magnetic orientation under the influence of an in-plane magnetic field.

3. A register as claimed in Claim 1, characterized in that the lamellar magnetic regions (2—13) comprise a permanent magnetic material, that the lamellar magnetic regions (2—13) are arranged in one plane and have a magnetization direction obliquely to the longitudinal axis of the conductor pattern.

4. A register as claimed in Claim 1, characterized in that the lamellar magnetic regions (2—13) are ion implanted regions in the magnetic layer.

5. A current-controlled magnetic domain memory having a main control path with which a number of information storage loops are coupled, which memory comprises a magnetizable layer in which magnetic deomains can be propagated and first and second conductor layers which are separated from each other by a non-magnetic, non-electically conductive intermediate layer parallel to the magnetizable layer and which define the direction of propagation of the magnetic domains, characterized in that the first conductor layer comprises a number of parallel registers as claimed in any of claims 1—4, and that the second conductor layer comprises a number of parallel registers as claimed in any of claims 1—4 which cross the registers of the first conductor layer with an angle of substantially 90°, in which a magnetic element is provided at the crossing points which is shared between the registers in the first and second layers, each two adjacent conductor patterns of the first layer together with two adjacent registers of the second layer defining an information storage loop.

6. A domain memory as claimed in Claim 5, characterized in that the registers of the first and second conductor layer have meandering conductor patterns which have the same meander periods.

7. A domain memory as claimed in Claim 5 or 6, characterized in that two adjacent conductor patterns of the first layer define a main control path and a loop-closing path respectively.

8. A domain memory as claimed in Claim 5 or 6, characterized in that three adjacent conductor patterns of the first layer define a main control path ($S_2$) present between two loop-closing paths ($S_1$ and $S_3$), the main control path ($S_2$) in conjunction with one loop-closing path and two successive conductor paths ($P_3$, $P_4$...) of the second conductor layer forming an information storage loop having a first direction of rotation, the main control path ($S_2$) in conjunction with the other loop-closing path and two successive conductor patterns ($P_4$, $P_5$...) of the second conductor layer forming an information storage loop having a second direction of rotation opposite to the first.

9. A domain memory as claimed in Claim 7 or 8, characterized in that the main control path ($S_2$) has a first end which is connected to a domain generator (36) and a second end which is connected to a domain detector (37).

10. A domain memory as claimed in any of Claims 5—9, characterized in that the registers of the first (30) and second (34) layer have control elements (33) which are all arranged in an intermediate layer (32) between the first and the second conductor layer.

11. A domain memory as claimed in any of Claims 5—9, characterized in that the registers of the first (24) and second (26) layer have control elements (28) which are all arranged in a layer which adjoins the free surface of the conductor layer (26) farthest remote from the magnetizable layer (23).

**Patentansprüche**

1. Register zur Fortpflanzung zylinderförmiger magnetischer Domänen in einer magnetisierbaren Schicht, von dem Typ, bei dem die zylinderförmigen magnetischen Domänen unter dem Einfluss eines bipolaren Stromatriebs über eine Bahn fortgepflanzt werden, die durch ein mäanderförmiges Leitermuster in Kombination mit längs der Längschse des Leitermusters angeordneten Steuerelementen (2—13), zwei je Mäanderperiode des Leitermusters, definiert wird, wobei das Leitermuster einen Leiter (1) mit einer Breite im wesentlichen nur eines Domänendurchmessers und mit einer Mäanderperiode von im wesentlichen vier Domänendurchmessern aufweist, und wobei die Seuerelemente (2—13) wenigstens im Betrieb des Registers magnetisiert werden um eine magnetische Gleichebenenorientierung darzustellen, die mit der Längsachse des Leitermusters einen Winkel von im wesentlichen 45° einschliesst, dadurch gekennzeichnet, dass die Steuerelemente (2—23) lamellierte magnetische Gebiete im wesentlichen quadratischen oder kreisrunden Querschnitts sind, die in dem magnetisierten Zustand Potentaltöpfe erzeugen, die je in der Ebene der magnetisierbaren Schicht ein Gebiet aufweisen, das im wesentlichen dem Querschnitt einer Domäne entspricht und dass die Steuerelemente (2—13) gegenüber der Achse des Mäanderleiters ausseraxiale Lagen haben um die Mitten der Domänen an den Rändern des Leitermusters zu stabilisieren, wenn der Strom durch das Leitermuster Null ist, wobei die Steuerelemente (2—13) im wesentlichen längs der Fortpflanzungsachse liegen.

2. Register nach Anspruch 1, dadurch gekennzeichnet, dass die lamellierten magnetischen Gebiete (2—13) ein weichmagnetisches Material aufweisen, in nur einer Ebene angeordnet sind und im Betrieb des Registers unter dem Einfluss eines Gleichebenenmagnetfields die Gewünschte magnetische Orientierung haben.

3. Register nach Anspruch 1, dadurch gekennzeichnet, dass die lamellierten magnetischen Gebiete (2—13) ein dauermagnetisches Material aufweisen, dass die lamellierten magnetischen Gebiete (2—13) in nur einer Ebene angeordnet sind und eine Magnetisierungsrichtung haben, die zu der Längsachse des Leitermusters schräg ist.

4. Register nach Anspurch 1, dadurch gekennzeichnet, dass die lamellierten magnetischen Gebiete (2—13) ionenimplantierte Gebiete in der magnetischen Schicht sind.

5. Stromgesteuerter Magnetdomänenspeicher mit einer Hauptsteuerstrecke, mit der eine Anzahl Informationsspeicherschleifen gekoppelt sind, wobei dieser Speicher eine magnetisierbare Schicht aufweist, in der magnetische Domänen fortgepflanzt werden können und mit einer ersten und einer zweiten Leiterschicht, die durch eine nichtmagnetische, nicht-elektrisch leitende Zwischenschicht parallel zu der magnetisierbaren Schicht voneinander getrennt sind und welche die Fortpflanzungsrichtung der magnetischen Domänen definieren, dadurch gekennzeichnet, dass die erste Leiterschicht eine Anzahl paralleler Register nach einem der Ansprüche 1—4 aufweist und dass die zweite Leiterschicht eine Anzahl paralleler Register nach einem der Ansprüche 1—4 aufweist, welch die Register der ersten Leiterschicht in einem Winkel von in wesentlichen 90° kreuzen, wobei an den Kreuzungen ein magnetisches Element vorgesehen ist, das den Registern in der ersten und in der zweiten Schicht gemeinsam ist, wobei jeweils zwei benachbarte Leitermuster der ersten Schicht zusammen mit zwei benachbarten Registern der zweiten Schicht eine Informationsspeicherschleife definieren.

6. Domänenspeicher nach Anspruch 5, dadurch gekennzeichnet, dass die Register der ersten und der zweiten Schicht mäanderförmige Leitermuster aufweisen, welche die gleichen Mäanderperioden haben.

7. Domänenspeicher nach Anspruch 5 oder 6, dadurch gekennzeichnet, dass zwei benachbarte Leitermuster der ersten Schicht eine Hauptsteuerstrecke bzw. eine Schleifenschliessstrecke definieren.

8. Domänenspeicher nach Anspruch 5 oder 6, dadurch gekennzeichnet, dass drei benachbarte Leitermuster der ersten Schicht einer Huaptsteuerstrecke ($S_2$ zwischen zwei Schleifenschliessstrecken ($S_1$ und $S_3$) definieren, wobei die Hauptsteuerstrecke ($S_2$) zusammen mit nur einer Schleifenschliesstrecke und zwei aufeinanderfolgenden Leiterstrecken ($P_3$, $P_4$...) der zweiten Leiterschicht eine Informationsspeicherschleife mit einer ersten Drehrichtung bilden, die hauptsteuerstrecke ($S_2$) zusammen mit der anderen Schleifenschliessstrecke und zwei aufeinanderfolgenden Leitermustern ($P_4$, $P_5$...) der zweiten Leiterschicht eine Informationsspeicherschleife mit einer zweiten Drehrichtung, die der ersten entgegengesetzt ist, bilden.

9. Domänenspeicher nach Anspruch 7 oder 8, dadurch gekennzeichnet, dass die Hauptsteuerstrecke ($S_2$) ein erstes Ende aufweist, das mit einem Domänengenerator (36) verbunden ist und ein zweites Ende, das mit einem Domänendetektor (37) verbunden ist.

10. Domänenspeicher nach einem der Ansprüche 5—9, dadurch gekennzeichnet, dass die Register der ersten (30) und zweiten (34) Schicht Steuerelemente (33) aufweisen, die alle in einer Zwischenschicht (32) zwischen der ersten und der zweiten Schicht vorgesehen sind.

11. Domänenspeicher nach einem der Ansprüche 5—9, dadurch gekennzeichnet, dass die Register der ersten (24) und der zweiten (26) Schicht Steuermittel (28) aufweisen, die alle in einer Schicht vorgesehen sind, die an die freie Oberfläche derjenigen Leiterschicht (26) grenzen, die am weitesten von der magnetisierbaren Schicht (23) entfernt ist.

**Revendications**

1. Registre pour la progagation de domaines magnétiques cylindriques dans une couche magnétisable du genre où les domaines magnétiques cylindriques sont propagés sous l'influence d'une commande à courant bipolaire suivant un trajet qui est défini par une configuration de conducteurs en forme de méandre en combinaison avec des éléments de commande (2—13) disposés suivant l'axe longitudinal de configuration de conducteurs, deux par période de méandre de la configuration de conducteurs, cette dernière comportant un conducteur (1) d'une largeur égale à environ un diamètre de domaine, et une période de méandre d'environ quatre diamètres de domaine, les éléments de commande (2—13) étant magnétisés, au moins pendant le fonctionnement du registre, pour présenter une orientation en plan magnétique, qui forme un angle d'environ 45° avec l'axe longitudinal de la configuration de conducteurs, caractérisée en ce que les éléments de commande (2—13) sont des régions magnétiques lamellaires d'une section transversale pratiquement carrée ou circulaire, engendrant, à leur état magnétisé, des puits de potentiel contenant chacun, dans le plan de la couche magnétisable, une région qui est pratiquement égale à la section transversale d'un domaine et que les éléments de commande (2—13) présentent des positions désaxées par rapport à l'axe du conducteur en méandre pour stabiliser les centres des domaines au bord de la configuration de conducteurs, lorsque le courant traversant la configuration de conducteurs est zéro, les éléments de commande (2—13) étant pratiquememt alignés suivant l'axe de propagation.

2. Registre selon la revendication 1, caractérisé en ce que les régions magnétiques lamellaires (2—13) constituées par un matériau magnétique doux sont disposées dans un plan et lors du fonctionnement du registre, elles présentent l'orientation magnétique requise sous l'influence de champ magnétique en plan.

3. Registre selon la revendication 1, caractérisé en ce que les régions magnétiques lamellaires (2—13) sont constituées par un matériau magnétique permanent, que les régions magnétiques lamellaires (2—13) sont disposées dans un plan et présentent une direction de magnétisation inclinée par rapport à l'axe longitudinal de la configuration de conducteurs.

4. Registre selon la revendication 1, caractérisé en ce que les régions magnétiques lamellaires (2—13) sont des régions implantées d'ions dans la couche magnétique.

5. Mémoire à domaines magnétiques commandée par du courant et présentant un trajet de commande principal auquel sont couplés plusieurs boucles de stockage d'information, mémoire qui est constituée par une couche magnétisable, dans laquelle peuvent être propagés le domaines magnétiques et des première et deuxième couches de conducteurs qui sont séparées l'une de l'autre par une couche intermédiaire non électroconductrice non magnétique parallèle à la couche magnétisable et qui définissent la direction de propagation des domaines mangétiques, caractérisé en ce que la première couche de conducteurs comporte plusieurs registres parallèles comme revendiqués dans l'une des revendications 1 à 4 et que la deuxième couche de conducteur comporte plusieurs registres parallèles comme revendiqués dans l'une des revendications 1 à 4, qui croisent les registres de la première couche de conducteurs sous un angle d'environ 90°, un élément magnétique étant prévu aux points de croisement et est commun aux registres dans les première et deuxième couches, chaque fois deux configurations de conducteurs adjacentes de la première couche, ensemble avec duex registres adjacents de la deuxième couche définissant une boucle de stockage d'information.

6. Mémoire à domaines selon la revendication 5, caractérisée en ce que les registres des première et deuxième couches de conducteurs présentent des configurations de conducteurs en méandres qui présentent les mêmes périodes de méandre.

7. Mémoire à domaines selon la revendication 5 ou 6, caractérisée en ce que les deux configurations de conducteurs de la première couche définissent un trajet de commande principal et un trajet de fermeture de boucle respectivement.

8. Mémoire à domaines selon la revendication 5 ou 6, caractérisée en ce que trois configurations de conducteurs successives de la première couche définissent un trajet de commande principal ($S_2$) entre deux trajets de fermeture de boucle ($S_1$ et $S_3$), le trajet de commande principal ($S_2$) en combinaison avec un trajet de fermeture de boucle et deux trajets de conducteurs successifs ($P_3$, $P_4$) de la deuxième couche de conducteurs formant une boucle de stockage d'information présentant une première direction de rotation, le trajet de commande principal ($S_2$) en combinaison avec l'autre trajet de fermeture de boucle et deux configurations de conducteurs successives ($P_4$, $P_5$...) de la deuxième couche de conducteurs formant une boucle de stockage d'information présentant une deuxième direction de rotation qui est opposée à la première direction de rotation.

9. Mémoire à domaines selon la revendication 7 ou 8, caractérisée en ce que le trajet de commande principal ($S_2$) présente une première extrémité, qui est connectée à un générateur de domaines (36) et une deuxième extrémité, qui est connectée à un détecteur de domaines (37).

10. Mémoire à domaines selon l'une des revendications 5 à 9, caractérisée en ce que les registres des première (30) et deuxième (34) couches présentent des éléments de commande (33), qui sont tous arrangés dans une couche intermédiaire (22) comprise entre les première et deuxième couches de conducteurs.

11. Mémoire à domaines selon l'une des revendications 5 à 9, caractérisée en ce que les registres des première (24) et deuxième (26) couches présentent des éléments de commande (28), qui sont tous disposés dans une couche, qui confine à la surface libre de la couche de conducteurs (26) la plus éloignée de la couche magnétisable (23).

# 0 065 797

FIG.1

FIG.2

FIG.3

FIG.4

FIG.5

FIG.5